# EUROPEAN PATENT APPLICATION

(11) **EP 2 743 977 A1**
(43) Date of publication of application: **18.06.2014**
(21) Application number: 12794159.9
(22) Date of filing: 20.08.2012
(51) Int. Cl.: H01L 21/77, H01L 29/786, H01L 27/12

(54) **OXIDE TFT ARRAY SUBSTRATE, MANUFACTURING METHOD THEREFOR, AND ELECTRONIC DEVICE**

(30) Priority: 22.08.2011 CN 201110241809
(71) Applicant: Boe Technology Group Co. Ltd., Beijing 100015 (CN)
(72) Inventor: YUAN, Guangcai, Beijing 100176 (CN); WU, Zhongyuan, Beijing 100176 (CN); DUAN, Liye, Beijing 100176 (CN)
(74) Representative: Klunker . Schmitt-Nilson . Hirsch
(86) International application number: PCT/CN2012/080380
(87) International publication number: WO 2013/026382

(57) **Abstract**

Embodiments of the present invention provide an oxide TFT array substrate and a method for manufacturing the same, and an electronic device comprising the same. In the embodiment of the method, an active layer and a stop layer are sequentially formed on a gate insulating layer and are patterned twice by a single-step continuous etch method. The embodiments of the present invention can avoid damages upon the surface and characteristics of an oxide semiconductor film during the processes such as removal, cleaning and the like, so the characteristics and yield of products can be effectively enhanced, and the costs for research and preparation are reduced.

## Description

### TECHNICAL FIELD

Embodiments of the invention are related to an oxide thin film transistor (TFT) array substrate, a method for manufacturing the same, and an electronic apparatus using the same.

### BACKGROUND

The initial researches on oxide thin film transistor (TFT) were conducted for the purposes of reducing power consumption of active displayers and resulted in the technology for making displayers thinner, lighter, and response faster. An organic light-emitting diode (OLED) panel of a new generation has an extra-thin profile, less weight, and low power consumption, and is of self-emission property, and can display images with more vivid colors and higher definition; now, OLED panels have already entered into a practical stage. Oxide TFT is also considered as a new technology which can replace the existing low temperature poly-silicon (LTPS) technology and be used for large-scale displays.

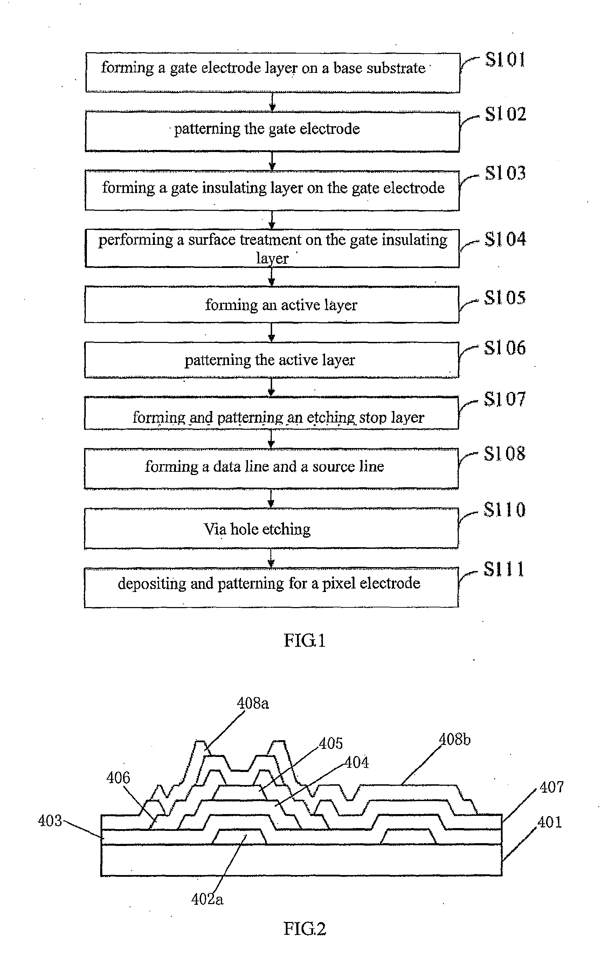

FIG.2 is a cross-sectional view of a conventional oxide TFT array substrate, and FIG. 1 is a flowchart of a method for manufacturing the conventional oxide TFT array substrate, which comprises steps S101∼S111. In the method, a gate electrode layer, an oxide semiconductor layer, an etching stop layer (ESL), a data line layer, a contact hole, and a pixel electrode are formed by six patterning processes, respectively.

An active layer of a TFT in the oxide TFT array substrate is formed of oxide semiconductor. Forming the active layer is a key process during manufacturing the oxide TFT array substrate, which comprises the following steps of:

S105, forming an oxide semiconductor active layer on a gate insulating layer; and

S 106, patterning the oxide semiconductor active layer.

In the aforesaid conventional process, the oxide semiconductor layer is patterned first in a patterning process; then photoresist is removed and cleaned off, and after that, an etching stop layer is deposited and patterned. The etching process for patterning the oxide semiconductor active layer may be wet etching or dry etching. Both wet etching and dry etching may cause damages onto the surface of the oxide semiconductor and thus reduce the property of the resultant products.

### SUMMARY

A technology problem to be solved by embodiments of the present invention is to provide a method for manufacturing an oxide TFT array substrate, which can reduce damages upon a surface and properties of an oxide semiconductor active layer.

One aspect of the invention provides a method for manufacturing the oxide thin film transistor (TFT) array substrate comprising steps:
M1, sequentially forming a gate electrode and a gate insulating layer on a base substrate;
M2, forming an active layer and a stop layer; and
M3, forming a source electrode, a drain electrode, a data line, a source line, and a contact hole, and preparing a pixel electrode;
wherein the step M2 comprises:
S305, forming the active layer on the gate insulating layer, the active layer comprises an oxide semiconductor material;
S306, forming the stop layer on the active layer;
S307, performing a patterning process on a laminated layer of the active layer and the stop layer;
S308, performing a second patterning process on the stop layer.

For example, in the step S307, the laminated layer of the active layer and the stop layer is patterned with an active layer mask plate.

For example, in the step S308, the stop layer is patterned the second time with a stop layer mask plate.

For example, in the step S307, the laminated layer of active layer and the stop layer is patterned by a dry etching or wet etching method.

For example, in the step S308, the stop layer is patterned the second time by a dry etching or wet etching method.

For example, in the step S305, the active layer is formed on the gate insulating layer with a magnetron sputtering deposition or solution deposition method.

For example, the oxide semiconductor material for the active layer is IGZO, ITGO, IZO, or ITO, or the like.

Another aspect of the invention also provides an oxide thin film transistor (TFT) array substrate, comprising a gate electrode, a source electrode, a drain electrode, a gate insulating layer, an active layer, a stop layer, a data line, and a pixel electrode, wherein the active layer and the stop layer are adjacent to each other and are patterned by single-step continuous etch method, and the active layer comprises an oxide semiconductor material.

For example, the oxide semiconductor material for the active layer is IGZO, ITGO, IZO, or ITO.

Still another aspect of the invention also provides an electronic device comprising the above described oxide TFT array substrate.

Without increasing the number of the mask exposing processes, the method for manufacturing the oxide TFT array substrate according to an embodiment of the invention omits the process of, after an oxide semiconductor layer is formed, patterning the oxide semiconductor layer in a first pattern process, and then further after removing, cleaning and so on, depositing a stop layer and the like. Therefore, damages upon the surface and characteristics of the oxide semiconductor film in the aforesaid process. Furthermore, in the embodiments of the invention, the active layer and the stop layer, which are sequentially formed, are patterned by a single-step continuous etch method, so the properties and the yield of products are effectively enhanced, and the costs for research and preparation are reduced.

### BRIEF DESCRIPTION OF THE DRAWINGS

In order to clearly illustrate the technical solution of the embodiments of the invention, the drawings of the embodiments will be briefly described in the following; it is obvious that the described drawings are only related to some embodiments of the invention and thus are not limitative of the invention.
FIG. 1 is a flowchart illustrating a method for manufacturing a conventional oxide TFT array substrate;
FIG.2 is a cross-sectional view of a conventional oxide TFT array substrate;
FIG.3 is a flowchart illustrating a method for manufacturing an oxide TFT array substrate according to an embodiment of the invention;
FIG.4A is a cross-sectional view of an oxide TFT array substrate after step S3301 according to an embodiment of the invention;
FIG.4B is a cross-sectional view of the oxide TFT array substrate after step S3302 according to an embodiment of the invention;
FIG.4C is a cross-sectional view of the oxide TFT array substrate after step S303 according to an embodiment of the invention;
FIG.4D is a cross-sectional view of the oxide TFT array substrate after step S305 according to an embodiment of the invention;
FIG.4E is a cross-sectional view of the oxide TFT array substrate after step S306 according to an embodiment of the invention;
FIG.4F is a cross-sectional view of the oxide TFT array substrate after step S307 according to an embodiment of the invention;
FIG.4G is a cross-sectional view of an oxide TFT array substrate after step S308 according to an embodiment of the invention;
FIG.4H is a cross-sectional view of the oxide TFT array substrate after depositing a metal layer in step S309 according to an embodiment of the invention;
FIG.4I is a cross-sectional view of the oxide TFT array substrate after step S309 according to an embodiment of the invention;
FIG.4J is a cross-sectional view of the oxide TFT array substrate after depositing a passivation layer in step S310 according to an embodiment of the invention;
FIG.4K is a cross-sectional view of the oxide TFT array substrate after step S310 according to an embodiment of the invention;
FIG.4L is a cross-sectional view of the oxide TFT array substrate after forming a pixel electrode layer in step S311 according to an embodiment of the invention;
FIG.5 is a cross-sectional view of an oxide TFT array substrate according to an embodiment of the invention.

401-substrate; 402-gate metal layer; 402a-gate electrode; 402b-auxiliary electrode line; 403-gate insulating layer; 4041-active layer; 404-patterned active layer; 4051-block layer; 4052-preliminary patterned block layer; 405-patterned block layer; 406-metal layer; 406a-drain electrode; 406b-source electrode; 407-passivation layer; 407a-contact hole; 408-pixel electrode layer; 408a-contact electrode; 408b-pixel electrode.

### DETAILED DESCRIPTION OF EMBODIMENTS

In order to make objects, technical details and advantages of the embodiments of the invention apparent, the technical solutions of the embodiment will be described in a clearly and fully understandable way in connection with the drawings related to the embodiments of the invention. It is obvious that the described embodiments are just a part but not all of the embodiments of the invention. Based on the described embodiments herein, those skilled in the art can obtain other embodiment(s), without any inventive work, which should be within the scope of the invention.

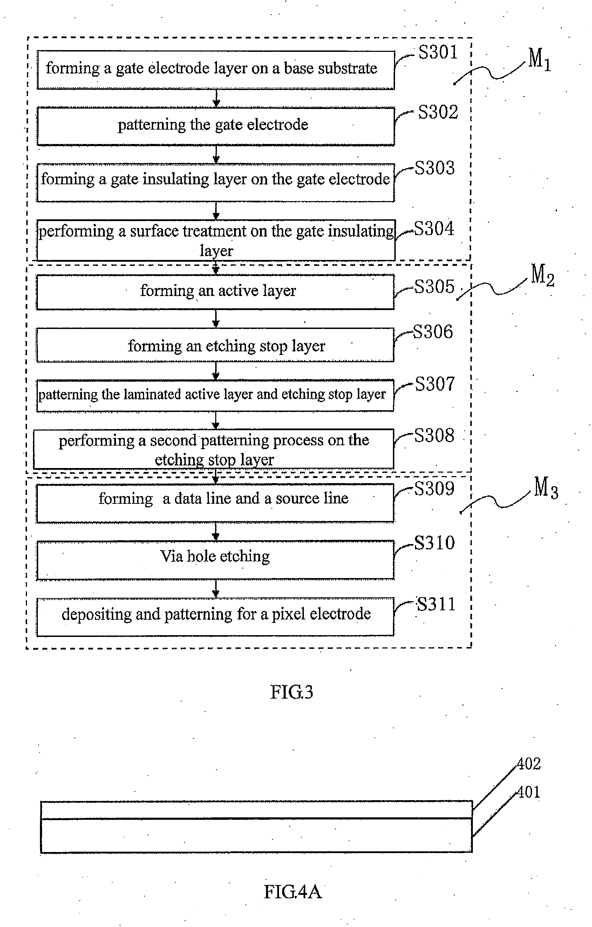

FIG.3 shows an embodiment of the invention provides a flowchart illustrating a method for manufacturing an oxide thin film transistor (TFT) array substrate according to an embodiment of the invention. FIGs.4A∼4L are across-sectional views illustrating processes for manufacturing an oxide TFT array substrate according to an embodiment of the invention. The detail is described as follow.

An oxide TFT array substrate of the present embodiment may comprise a plurality of gate lines and a plurality of data lines, which intersect each other and define a plurality of pixel units arranged in a matrix. Each pixel unit comprises a TFT as an active switch element and a pixel electrode. Of the TFT in one pixel unit, a gate electrode is electrically connected to or formed integrally with a corresponding gate line, a source electrode is electrically connected to or formed integrally with a corresponding date line, and a drain electrode is connected to the corresponding pixel electrode. In another embodiment, an array substrate may also comprise a common electrode which can form a driven electric filed together with a pixel electrode. The following description only corresponds to one pixel unit of the TFT, while other TFTs also can be formed similarly.

S301, forming a gate electrode layer on a base substrate.

As shown in FIG.4A, a gate metal layer 402 is formed on a base substrate, for example, a glass substrate 401, by using a magnetron sputtering method. The material of the gate metal layer 402 can be selected based on requirements according to various device structures and preparation processes. In general, the gate metal layer comprises Mo, Cu, Ti, any alloy thereof, or the like. The gate metal layer may have a thickness of 200nm-350nm, so that the square resistance of the gate metal layer can be kept at a relatively low level.

S302, patterning the gate metal layer.

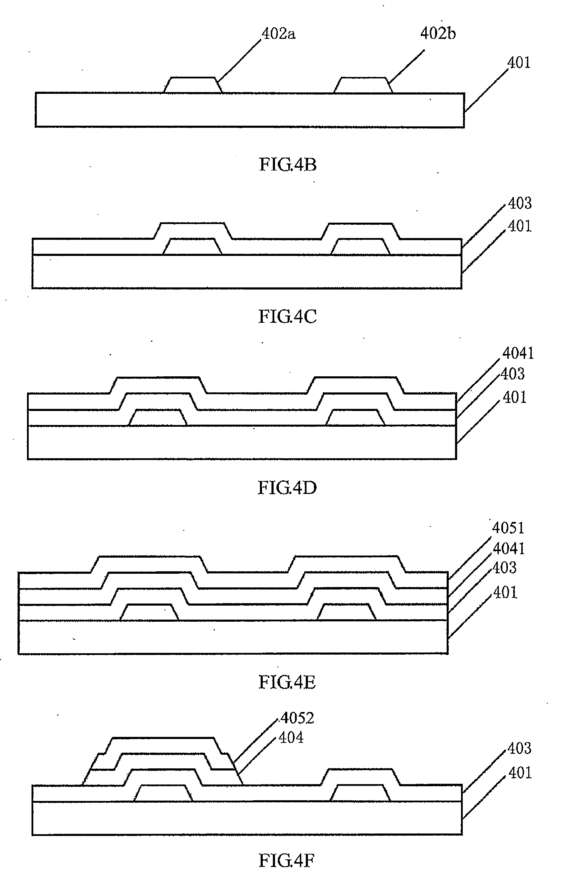

A photoresist mask is formed by a photolithography process, and the gate metal layer 402 is patterned by a wet etching process with the photoresist mask so as to form a gate electrode 402a as shown in FIG.4B. Meanwhile, this step also may form a gate line (not shown) and an auxiliary electrode line 402b, and the gate line is formed integrally with the gate electrode 402a, for example. The auxiliary electrode line 402b is used to form an auxiliary capacitor, for example. In another embodiment, the auxiliary electrode line 402b may not be formed.

S303, forming a gate insulating layer 403 on the gate electrode.

As shown in FIG.4C, after patterning of the gate electrode, the base substrate 401 with a gate pattern thereon is cleaned in a pre-clean process, and a gate insulating layer 403 is prepared on the base substrate 401 having the gate pattern by a PECVD process. The gate insulating layer 403 is formed of SiO₂ film, SiNₓ film, SiOₓN_{y} film, Al₂O₃ film, TiOₓ film or multi-layered structure film.

S304, performing surface treatment on the gate insulating layer.

During preparing a TFT, the surface characteristics of the gate insulating layer significantly effect the characteristics of the whole TFT, and especially plays an important role to the oxide TFT. In the present embodiment, the gate insulating layer 403 is treated or modified with plasma on the surface. However, if the gate insulating layer 403 already has proper surface characteristics, the surface treatment may be omitted.

S305, forming an active layer.

Forming of an active layer 404 is a key step during manufacturing the oxide TFT. The active layer of the present embodiment is formed of an oxide semiconductor material. In the embodiment, the oxide semiconductor material for the active layer 4041 is formed on the gate insulating layer 403 by using a magnetron sputtering method, as shown in FIG.4D. The oxide semiconductor material comprises indium gallium zinc oxide (IGZO), indium gallium tin oxide (ITGO), indium zinc oxide (IZO), indium tin oxide (ITO), or other composite with different ratios.

S306, forming an etching stop layer.

As shown in FIG.4E, an etching stop layer (referred to stop layer) 4051 is directly formed on the active layer 403. The stop layer 405 can be formed of different materials according to different processes, and may be inorganic insulating material such as, SiOₓ, SiNₓ, SiOₓN_{y}, Al₂O₃, TiOₓ, or the like, for reducing the damages occurred to the oxide semiconductor film during patterning the data line.

After sequentially forming the active layer 4041 and the stop layer 4051, the active layer 4041 and the stop layer 4051 are patterned by a single-step continuous etch (SCEM) method, an exemplary step of which comprises S307 and S308, which are described below.

S307, patterning the active layer 4041 and the stop layer 4051.

A photoresist mask is formed by a photolithography process with a mask plate for an active layer pattern, and the lamination structure of the active layer 4041 and the stop layer 4051 is patterned with the photoresist mask. The stop layer 4051 is firstly patterned by using a dry etching method; after etching of the stop layer 4051, the active layer 4041 is patterned. Therefore, as shown in FIG.4F, the patterned active layer 4052 and the patterned active layer 404 are formed.

S308, performing a second patterning process on the patterned stop layer 4052.

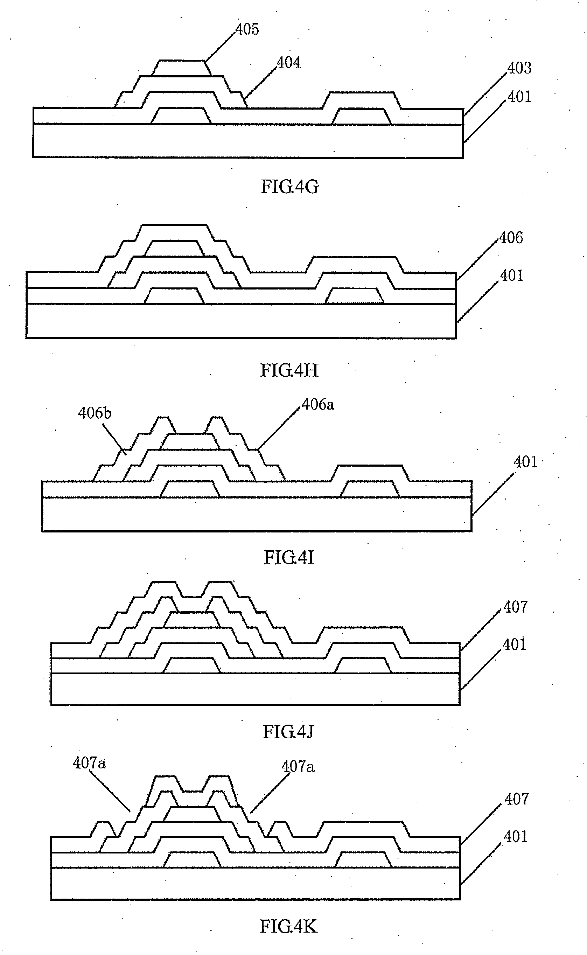

A photoresist mask is formed by a photolithography process with a mask plate for a stop layer pattern, and the stop layer 4052 is patterned again with the photoresist mask so as to obtain the patterned stop layer 405, as shown in FIG.4G. In the present embodiment, the stop layer 4052 is etched by a dry etching process.

S309, forming a source electrode, a drain electrode, a data line, and a source line.

Firstly, a metal layer 406 is deposited for example by a magnetron sputtering method, as shown in FIG.4H.

Then, a photoresist mask is formed by a photolithography process, and the metal layer 406 is patterned by a wet etching method with the photoresist mask, so as to form the source and drain electrodes 406a and 406b of the TFT, the data line, and a source line (which is not shown and may be used in an OLED display). The resultant structure is shown in FIG.4I. Herein, for example, the source electrode 406b is formed integrally with the data line. The patterned metal layer may also be referred to a data line layer.

The material of the metal layer 406 can be selected based on requirements according to various structures of the device and preparation processes. For example, the metal layer can be made of Mo, Mo/Al/Mo alloy, Mo/Al-Nd/Mo lamination structure, Cu and Ti and an alloy thereof, or the like. The metal layer 406 has a thickness of 100nm∼350nm, so that the square resistance of the metal layer is kept at a relatively low level.

S310, forming a passivation layer and forming a contact hole.

After forming the source and drain electrodes of the TFT, the data line, the source line and so on, a passivation layer 407 is formed on the entire base substrate 401, as shown in FIG.4J. The passivation layer 407 can be formed of inorganic material, for example SiOₓ, SiNₓ, SiOₓN_{y}, Al₂O₃, or TiOₓ.

A photoresist mask is formed by a photolithography process, and the passivation layer 407 is etched with the photoresist mask to form a contact hole 407 for connecting the drain electrode of the TFT with the pixel electrode to be formed later. The contact hole 407a is shown in FIG.4K.

S311, depositing and patterning for a pixel electrode.

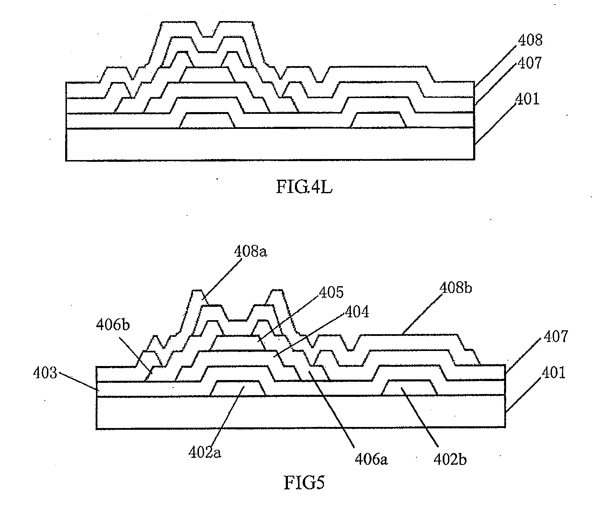

As shown in FIG.4L, after forming the contact hole 407a, a pixel electrode layer 4081 is formed, and the material of the pixel electrode layer 4081 may be for example indium thin oxide (ITO), indium zinc oxide (IZO), tin oxide, or the like.

A photoresist pattern is formed by a photolithography process, and the pixel electrode layer 4081 is patterned by a wet etching method with the photoresist pattern as a mask, so as to form a contact electrode 408a and a pixel electrode 408b. The resultant structure is shown in FIG.5.

In present embodiment, the gate electrode layer, the active layer, the stop layer, the data line layer, the contact hole, and the pixel electrode are formed sequentially in six photolithography processes (mask exposing processes). Without increasing the mask exposing processes, the oxide semiconductor active layer is properly protected by using the SCEM method, and direct irradiation and etching on the channel region of the active layer can be avoided. Thus the characteristics of the TFT are improved, the yield of the array substrate is increased, and the costs are reduced.

For example, in the step S305 of the above embodiment, methods such as magnetic sputtering, solution deposition, or the like may be used to form the oxide semiconductor layer for the active layer on the gate insulating layer.

For example, in the steps S307 and S308 of the above embodiment, the active layer and the stop layer are patterned by a dry etching or wet etching method.

Another embodiment of the present invention further provides an oxide TFT array substrate, which is prepared by the above described method, as shown in FIG.5. The oxide TFT array substrate comprises the base substrate 401 and the gate line, the thin film transistor, data line, and the pixel electrode 408b formed on the base substrate 401; the thin film transistor comprises the gate electrode 402a, the source electrode 406b, the drain electrode 406a, the gate insulating layer 403, the active layer 404, and the stop layer 405, and the active layer and the stop layer are patterned by a SCEM process. The active layer may be formed of IGZO, ITGO, IZO, or ITO. Since the active layer is properly protected by using the SCEM method, direct irradiation and etching upon the channel region of the active layer can be avoided, the characteristics of the TFT are improved, the higher yield is realized, and the costs are lowered. In the embodiment, the oxide TFT array substrate further comprises an auxiliary electrode line 402b, but on the other hand this auxiliary electrode line 402b may be not formed.

The oxide TFT array substrate of present embodiment may be used in a liquid crystal display panel, an OLED display panel, an electronic paper display apparatus, or the like.

Still another embodiment of the present invention further provides an electronic device comprising the above described array substrate. The electronic device may be a liquid crystal display panel, an electronic paper display, an OLED display, a cell phone, a tablet PC, or the like.

The above only describes the preferred embodiments of the present invention. It should be noted that change and modifications in the solutions of the invention can be made by those skilled in the art without depart from the spirit and scope of the invention, these change and modifications are also within the scope of the present invention.

## Claims

1. A method for manufacturing an oxide thin film transistor (TFT) array substrate, comprising steps of:
M1, sequentially forming a gate electrode and a gate insulating layer on a base substrate;
M2, forming an active layer and a stop layer;
M3, forming a source electrode, a drain electrode, a data line, a source line, and a contact hole, and preparing a pixel electrode;
wherein the step M2 comprises:
S305, forming the active layer on the gate insulating layer, the active layer comprising an oxide semiconductor material;
S306, forming the stop layer on the active layer;
S307, performing a patterning process on a laminated layer of the active layer and the stop layer; and
S308, performing a second patterning process on the stop layer.

2. The method of claim 1, wherein, in the step S307, the laminated layer of the active layer and the stop layer is patterned with an active layer mask plate.

3. The method of claim 1 or 2, wherein, in the step S308, the stop layer is patterned the second time with a stop layer mask plate.

4. The method of any one of claims 1-3, wherein, in the step S307, the laminated layer of the active layer and the stop layer is patterned by a dry etching or wet etching method.

5. The method of any one of claims 1-4, wherein, in the step S308, the stop layer is patterned the second time by a dry etching or wet etching method.

6. The method of any one of claims 1-5, wherein, in the step S305, the active layer is formed on the gate insulating layer with a magnetron sputtering deposition or solution deposition method.

7. The method of any one of claims 1-6, wherein the oxide semiconductor material for of the active layer is IGZO or ITGO.

8. An oxide thin film transistor (TFT) array substrate, comprising a gate electrode, a source electrode, a drain electrode, a gate insulating layer, an active layer, a stop layer, a data line, and a pixel electrode, wherein the active layer and the stop layer are adjacent to each other and are patterned by a single-step continuous etch method, and the active layer comprises an oxide semiconductor material.

9. The oxide TFT array substrate of claim 8, wherein the oxide semiconductor material for the active layer is IGZO or ITGO.

10. An electronic device comprising the oxide TFT array substrate of claim 8 or 9.
